# EUROPEAN PATENT SPECIFICATION

(11) **EP 3 985 742 B1**
(45) Date of publication and mention of the grant of the patent: **31.05.2023**
(21) Application number: 20839913.9
(22) Date of filing: 16.07.2020
(51) Int. Cl.: H01L 31/05, H01L 31/044

(54) **HOT-SPOT-RESISTANT SINGLE-PLATE PHOTOVOLTAIC MODULE**
HOT-SPOT-BESTÄNDIGE EINZELPLATTEN-FOTOVOLTAIKMODUL
MODULE PHOTOVOLTAÏQUE MONOPLAQUE RÉSISTANT AUX POINTS CHAUDS

(30) Priority: 18.07.2019 CN 201910649245
(43) Date of publication of application: 20.04.2022
(73) Proprietor: Jiangsu Coop&Inno Green Energy Technology Co., Ltd, Wuxi, Jiangsu 214437 (CN)
(72) Inventor: ZHANG, Guoming, Suzhou, Jiangsu 215127 (CN); TAO, Aibing, Suzhou, Jiangsu 215127 (CN)
(74) Representative: Bayramoglu et al.
(86) International application number: PCT/CN2020/102274
(87) International publication number: WO 2021/008573

(56) References cited:
- WO-A1-2018/057362
- CN-A- 106 298 987
- CN-A- 109 509 800
- CN-A- 109 801 995
- CN-A- 109 801 995
- CN-A- 109 801 995
- CN-A- 110 212 051
- CN-U- 201 478 310
- CN-U- 201 478 310
- CN-U- 208 923 172
- CN-U- 209 328 928
- JP-A- S61 154 083
- JP-A- S61 154 083
- US-A1- 2009 314 330
- US-A1- 2018 204 968

## Description

### TECHNICAL FIELD

The present invention relates to the technical field of solar cell modules, and more particularly, to a hot spot-resistant single-plate photovoltaic module.

### BACKGROUND

With the rise of energy prices, the development and utilization of new energy have currently become a main research topic in the energy field. Since solar energy has the advantages of being pollution-free, is not regionally restricted, and inexhaustible, the research on solar power generation has become the main direction for the development and utilization of new energy. Using solar cells to generate power is one of the main ways to use solar energy today. It is an inevitable trend in the industry to promote high conversion efficiency, continuous manufacturing cost reduction, and performance improvement of modules.

The existing laminated photovoltaic module is a mainstream product with high conversion efficiency, in which cells may be connected in series by using solder ribbons or conductive adhesive. However, due to high resistance, high process technology requirements, and high material costs of conductive adhesive, a production yield of the laminated photovoltaic module is low, product maintenance is inconvenient, and product prices are high. Moreover, since the laminated module adopts a horizontal connection mode, when the cell cracks horizontally, the entire cell string or even the entire photovoltaic module is unable to generate power. The photovoltaic module has poor hot spot resistance, leaving the photovoltaic module at risk of being burnt out.

The existing metallization wrap-through (MWT) photovoltaic modules and interdigitated back contact (IBC) photovoltaic modules have copper foil arranged on the back side for circuitry, having the disadvantages of complex processes, proneness to short circuit, low production yield, high connection material usage, high cost, and low-cost performance.

A conventional laminated photovoltaic module uses 1/5 cells, which can only be arranged horizontally and cannot be arranged vertically. The horizontal arrangement requires higher processing costs, increasing the costs of the photovoltaic module.

The conventional laminated module uses one or two diodes to protect the photovoltaic module. Based on the reverse leakage current feature of the cells, one diode can protect up to 20 cells to achieve the best effect. Since the cells of the laminated photovoltaic module are relatively small and the number of cells connected in series is relatively large, using only one or two diodes to protect the photovoltaic module is far from being sufficient. In the case of shading, the diodes of the photovoltaic module will not work, which reduces the conversion efficiency and causes the entire photovoltaic module to heat up, reducing the service life of the photovoltaic module.

Regarding the patent ZL201621351622.X "SOLAR CELL PANEL AND MODULE", in the actual production process, the number of cells is still large, the diode processing is troublesome, two panels need to be connected in series to form a circuit, the overall production of the module requires a lot of crafting actions, including panel arrangement, panel fastening, and panel circuit connection, but the ability to automate the production process still needs to be further improved. CN109801995A discloses a solar cell module, and the solar cell module comprises a plurality of cells distributed in an m*n matrix, wherein m is the number of rows, n is the number of columns, and m and n are integers greater than 1. The plurality of cells are connected in a grid connection manner, wherein the positive and negative electrodes of the cells in each column are connected in series through conductive pieces, the positive electrodes of the cells in each row are connected through conductive pieces, and the negative electrodes of the cells in the n-th row are connected through conductive pieces. Each cell in the first column of battery pieces is provided with a diode in a parallel manner. WO2018/057362A1 discloses a PV cell design which introduces one or multiple additional electrical contacts on a PV cell. For PV modules that are constructed with shingled PV cells, this invention aims to make it convenient to: 1) connect metal ribbons to shingled PV strings only from the rear side of the PV cells; 2) incorporate by-pass diodes; and 3) establish inter-string connection. US2018/204968A1 discloses a back-contact cell module including cells and connecting ribbons.

### SUMMARY

### Technical Problem

The production yield of laminated photovoltaic modules is low, product maintenance is inconvenient, and product prices are high. Moreover, since the laminated module adopts a horizontal connection mode, when a cell cracks horizontally, the entire cell string or even the entire photovoltaic module is unable to generate power. The photovoltaic module has poor hot spot resistance, leaving the photovoltaic module at risk of being burnt out.

### Solution to the Problem

### Technical Solution

The invention is set out in the appended set of claims.

### Advantages of the Present Invention

### The Advantages

The cell array in the hot spot-resistant single-plate photovoltaic module of the present invention adopts a single-plate design. The cells in the same row are connected in parallel by the solder ribbons, and cells in the same column are connected in series by the solder ribbons, and then a current is led out through the bus bar. Multiple diodes are arranged in parallel to the cells to protect the cells between the diodes. In the case of shading, the diodes can respond easily and provide bypass protection for the cells in a shaded area, and most of the cells can generate power normally. In this way, the power generation efficiency and actual power generation of the photovoltaic module can be improved, the hot spot-resistant capability of the photovoltaic module can be enhanced, and the service life of the photovoltaic module can be prolonged. Also, the manufacturing process is simplified, adapting to the development needs of high automation.

### BRIEF DESCRIPTION OF THE DRAWINGS

### Description of the Drawings

FIG. 1 is a schematic diagram of a circuit of a hot spot-resistant single-plate photovoltaic module according to the present invention.
FIG. 2 is a first schematic structural diagram of a hot spot-resistant single-plate photovoltaic module according to the present invention.
FIG. 3 is a second schematic structural diagram of a hot spot-resistant single-plate photovoltaic module according to the present invention.
FIG. 4 is a first schematic diagram of a soldering manner of cells and solder ribbons of a hot spot-resistant single-plate photovoltaic module not part of the present invention.
FIG. 5 is a first stereogram of a soldering manner of a cell array of a hot spot-resistant single-plate photovoltaic module not part of the present invention.
FIG. 6 is a second schematic diagram of a soldering manner of cells and solder ribbons of a hot spot-resistant single-plate photovoltaic.
FIG. 7 is a second stereogram of a soldering manner of a cell array of a hot spot-resistant single-plate photovoltaic module.

Reference signs: 1. cell; 2. solder ribbon; 3. bus bar; and 4. diode.

### DETAILED DESCRIPTION OF THE EMBODIMENTS

### Implementations of the Present Invention

The technical solutions of the embodiments of the present invention are clearly and completely described below with reference to the drawings. Apparently, the described embodiments are merely a part, not all, of the embodiments of the present invention. All other embodiments obtained by the ordinary skilled in the art on the basis of the embodiments of the present invention without creative efforts shall fall within the protection scope of the present invention.

The objectives of present invention are to provide a photovoltaic module with strong hot spot resistance.

To make the above objectives, features, and advantages of the present invention clearer and more comprehensible, the present invention will be further described in detail below with reference to the drawings and the specific implementations.

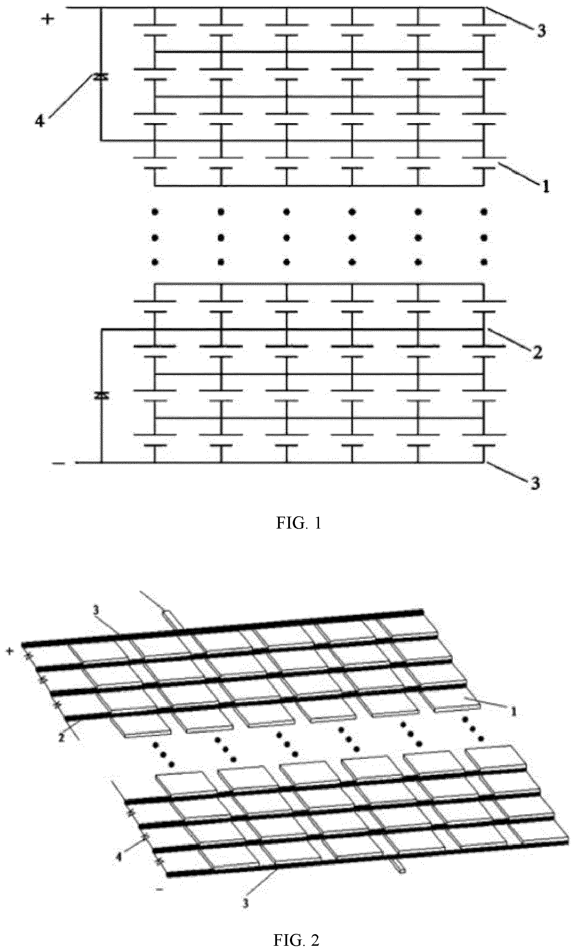

As shown in FIG. 1, a hot spot-resistant single-plate photovoltaic module of the present invention includes cells 1, solder ribbons 2, bus bars 3, and diodes 4.

A plurality of cells 1 are arranged in a matrix and connected by the solder ribbons 2 and the bus bars 3 to form a cell array; the cells 1 in the same row are connected in parallel by one of the solder ribbons 2, and the cells 1 in the same column are connected in series by the solder ribbons 2; head cells, as well as tail cells, of the cell array are separately connected by one of the bus bars 3 for collecting and leading out currents; and the diodes 4 are connected in parallel to the cells 1.

The hot spot-resistant single-plate photovoltaic module further includes a junction box, where the diodes 4 are arranged in the junction box, and the solder ribbons 2 and the bus bars 3 extend outward to connect to the diodes 4 in the junction box.

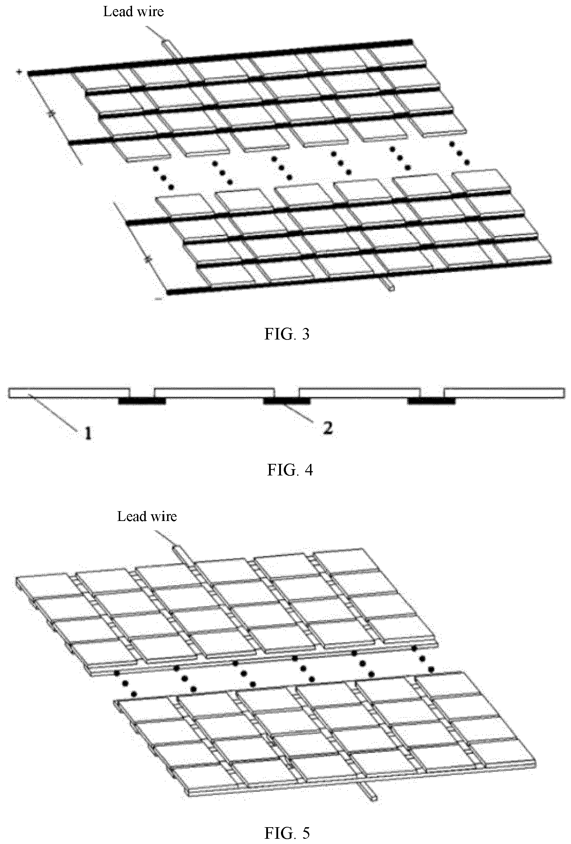

The diodes 4 may be connected in two manners: 1. single-row protection, in which the diode 4 is connected in parallel between positive and negative electrodes of a single row of the cells 1 through the solder ribbon 2 or the bus bar 3 (as shown in FIG. 2), to provide a maximum protection for the photovoltaic module; 2. multi-row protection, in which the diode 4 is connected in parallel between positive and negative electrodes of multiple rows of the cells 1 through the solder ribbons 2 or the bus bars 3, to reduce the cost of the photovoltaic module. In this embodiment, the diode 4 is connected in parallel between positive and negative electrodes of three rows of the cells 1 through the solder ribbon 2 or the bus bar 3 (as shown in FIG. 3).

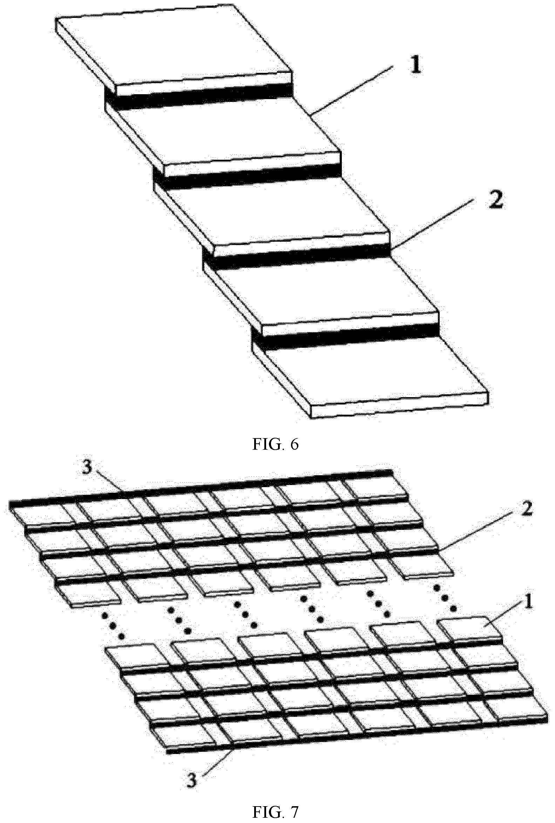

The cell 1 is a crystalline silicon cell, and the crystalline silicon cell is a shingle solar cell with main grid lines on its front and back sides. In examples useful for understanding the invention but not part thereof, the crystalline silicon cell is any one of an interdigitated back contact (IBC) silicon solar cell, a metallization wrap-through (MWT) silicon solar cell. When the crystalline silicon cell is the IBC silicon solar cell or MWT silicon solar cell, the cell 1 and the solder ribbon 2 are connected by lamination, that is, a back side of a lower end of the cell 1 in front of the solder ribbon 2, the solder ribbon 2, and a back side of an upper end of the cell 1 behind the solder ribbon 2 are connected in a laminated manner, as shown in FIG. 4 and FIG. 5. When the crystalline silicon cell is the shingle solar cell, the cell 1 and the solder ribbon 2 are parallelly connected, as shown in FIG. 6 and FIG. 7.

The cell 1 is a sliced cell, and the sliced cell is formed by cutting the crystalline silicon cell into 1/2 to 1/12; and the cell is any one of 1/2, 1/3, 1/4, 1/5, 1/6, 1/7, 1/8, 1/9, 1/10, 1/11, and 1/12.

The hot spot-resistant single-plate photovoltaic module further includes a first protective layer, a second protective layer, and an adhesive film layer, where
the first protective layer is located on one side of the cell array;
the second protective layer is located on the other side of the cell array; and
the adhesive film layer is provided between the cell array and the first protective layer and between the cell array and the second protective layer, and the adhesive film layer is used to connect the cell array, the first protective layer, and the second protective layer as a whole.

The diode 4 may be installed in the junction box or sandwiched between the first protective layer and the second protective layer.

The first protective layer is located on an illuminated surface of the cell array, and the first protective layer is a plate structure, is made of a glass material or a transparent organic composite material, and is used to increase structural strength, improve load resistance and crack resistance, and prevent foreign bodies from directly impacting the module. The second protective layer is located on the back side of the illuminated surface of the cell array, and the second protective layer is a plate structure, is made of a material of the first protective layer, polyethylene terephthalate (PET), a composite material containing PET, or glass, and is used to improve load resistance and crack resistance.

The adhesive film layer is made of any one of ethylene vinyl acetate (EVA), polyolefin elastomer (POE), polyvinyl butyral (PVB), and silica gel.

The hot spot-resistant single-panel photovoltaic module further includes: a frame, configured to wrap four sides of a whole formed by connecting the cell array, the first protective layer, the second protective layer, and the adhesive film layer to prevent the four sides of the whole from being damaged by external force.

The hot spot-resistant single-plate photovoltaic module of the present invention has a simple circuit structure and adopts a single-plate design. The solder ribbons run through the entire cell array to connect the cells in the same row in parallel, and to connect the cells in the same column in series, and the cells are protected by using multiple diodes. This eliminates the conventional string or multi-plate arrangement, spares the need of fastening strings/plates by using tapes, eliminates the need of separately soldering the bus bars, reduces the material usage of the solder ribbons and bus bars, realizes a most simplified manufacturing method and process, such that automated manufacturing can be achieved. In addition, the quantity and positions of diodes can be flexibly selected based on the type, size, and quantity of cells, meeting the need for hot spot resistance of the photovoltaic module in different conditions.

The embodiments are described herein in a progressive manner. Each embodiment focuses on the difference from another embodiment, and the same and similar parts between the embodiments may refer to each other.

Specific examples are used herein for illustration of the principles and implementations of the present invention. The ordinary skilled in the art can make various modifications to the specific implementations and scope of application in accordance with the scope of the present invention as defined by the subject-matter of the claims. In conclusion, the content of this specification shall not be construed as a limitation to the present invention.

## Claims

1. A hot spot-resistant single-plate photovoltaic module, comprising: cells (1), solder ribbons (2), two bus bars (3), and diodes (4), wherein a plurality of cells (1) are arranged in a matrix and connected by the solder ribbons (2) and the bus bars (3) to form a cell array; one bus bar is at upper end of the cell array and the other bus bar is at lower end of the cell array;
the cells (1) in the same column of the cell array are connected in series by the solder ribbons (2); the head cells (1), as well as the tail cells (1), of the cell array are separately connected by one of the bus bars (3) for collecting and leading out currents; the diodes (4) are located between the solder ribbons (2) and between the bus bar (3) and the solder ribbon (2), and the diodes (4) are connected in parallel to the cells (1); wherein the cells (1) in a row are separated by a gap; the solder ribbons (2) and the bus bars (3) are parallel to the direction of the cells (1) in same row of the cell array; the cells (1) each are a crystalline silicon cell, the crystalline silicon cell is a shingle solar cell; **characterized in that**
the cells (1) in the same row of the cell array are connected in parallel by two of the solder ribbons (2) or by one of the solder ribbons (2) and one of the bus bars (3), wherein in the case of two solder ribbons (2): one of the solder ribbons (2) is on front side of the cells (1) in the same row of the cell array, at upper end of the cells that is parallel to the cell row direction while other ribbon is on back side of the cells (1), at lower end of the cells (1) that is parallel to the cell row direction, in the case of one solder ribbon (2) and one bus bar (3): one of the solder ribbon (2) and the bus bar (3) is on front side of the cells (1) in the same row of the cell array, at upper end of the cells that is parallel to the cell row direction while other one is on back side of the cells (1), at lower end of the cells (1) that is parallel to the cell row direction; the cell (1) and the solder ribbon (2) are parallelly connected, such that from the two solder ribbons (2) of the same row or from one solder ribbon (2) and one bus bar (3) of the same row, one solder ribbon is common to two adjacent rows of cells, runs through whole row of cells, is sandwiched between the two rows of cells, is on the front side of the cells of one row and on the back side of the cells of other row, and connects corresponding cells of the two rows in series in a tile-like manner, and one bus bar (3) runs through the whole row of cells.

2. The hot spot-resistant single-plate photovoltaic module according to claim 1, wherein the diodes (4) are located between the solder ribbons (2) in adjacent rows and between the bus bar (3) and the solder ribbon (2) in the adjacent rows, and are connected in parallel between positive and negative electrodes of a single row of the cells (1) to realize single-row protection.

3. The hot spot-resistant single-plate photovoltaic module according to claim 1, wherein the diodes (4) are located between the solder ribbons (2) spaced by N rows and between the bus bar (3) and the solder ribbon (2) spaced by N rows, and are connected in parallel between positive and negative electrodes of multiple rows of the cells (1) to realize a multi-row protection, wherein N is a natural number greater than or equal to 1.

4. The hot spot-resistant single-plate photovoltaic module according to claim 1, wherein the hot spot-resistant single-plate photovoltaic module further comprises a junction box, wherein the diodes (4) are arranged in the junction box, and the solder ribbons (2) and the bus bars (3) extend outward to connect to the diodes (4) in the junction box.

5. The hot spot-resistant single-plate photovoltaic module according to claim 1, wherein the cells (1) each are a sliced cell, and the sliced cell is formed by cutting the crystalline silicon cell into 1/2 to 1/12, wherein the cell (1) is any one of 1/2, 1/3, 1/4, 1/5, 1/6, 1/7, 1/8, 1/9, 1/10, 1/11, and 1/12.

## Patentansprüche

1. Lichtpunktbeständiges Einzelplattenfotovoltaikmodul, umfassend: Zellen (1), Lotbänder (2), zwei Sammelschienen (3) und Dioden (4), wobei eine Vielzahl von Zellen (1) in einer Matrix angeordnet ist und durch die Lotbänder (2) und die Sammelschienen (3) zu einer Zellanordnung verbunden ist; eine Sammelschiene sich am oberen Ende der Zellanordnung und die andere Sammelschiene sich am unteren Ende der Zellanordnung befindet;
die Zellen (1) in derselben Spalte der Zellanordnung durch die Lotbänder (2) in Reihe geschaltet sind; die Kopfzellen (1) und die Schwanzzellen (1), der Zellanordnung durch eine der Sammelschienen (3) separat verbunden sind, um Strom aufzunehmen und herauszuführen; die Dioden (4) zwischen den Lotbändern (2) und zwischen der Sammelschiene (3) und dem Lotband (2) liegen und die Dioden (4) mit den Zellen (1) parallel geschaltet sind; wobei die Zellen (1) in einer Zeile durch einen Spalt getrennt sind; die Lotbänder (2) und die Sammelschienen (3) parallel zur Richtung der Zellen (1) in derselben Zeile der Zellanordnung sind; die Zellen (1) jeweils eine Zelle aus kristallinem Silizium sind, wobei die Zelle aus kristallinem Silizium eine Schindelsolarzelle ist; **dadurch gekennzeichnet, dass**
die Zellen (1) in derselben Zeile der Zellanordnung durch zwei der Lotbänder (2) oder durch eins der Lotbänder (2) und eine der Sammelschienen (3) parallel geschaltet sind, wobei im Fall von zwei Lotbändern (2): eins der Lotbänder (2) auf der Vorderseite der Zellen (1) in derselben Zeile der Zellanordnung am oberen Ende der Zellen liegt, das parallel zur Zellzeilenrichtung ist, während das andere Band auf der Rückseite der Zellen (1) am unteren Ende der Zellen (1) liegt, das parallel zur Zellzeilenrichtung ist, im Fall von einem Lotband (2) und einer Sammelschiene (3): eins von dem Lotband (2) und der Sammelschiene (3) auf der Vorderseite der Zellen (1) in derselben Zeile der Zellanordnung am oberen Ende der Zellen liegt, das parallel zur Zellzeilenrichtung ist, während das andere auf der Rückseite der Zellen (1) am unteren Ende der Zellen (1) liegt, das parallel zur Zellzeilenrichtung ist, die Zelle (1) und das Lotband (2) parallel geschaltet sind, derart, dass von den zwei Lotbändern (2) derselben Zeile oder von dem einen von Lotband (2) und Sammelschiene (3) derselben Zeile ein Lotband zwei benachbarten Zeilen von Zellen gemeinsam ist, durch die gesamte Zeile von Zellen verläuft, zwischen den zwei Zeilen von Zellen angeordnet ist, auf der Vorderseite der Zellen einer Zeile und auf der Rückseite der Zellen der anderen Zeile liegt und entsprechende Zellen der beiden Zeilen in kachelartig in Reihe schaltet, und eine Sammelschiene (3) durch die gesamte Zeile von Zellen verläuft.

2. Lichtpunktbeständiges Einzelplattenfotovoltaikmodul nach Anspruch 1, wobei die Dioden (4) zwischen den Lotbändern (2) in benachbarten Zeilen and zwischen der Sammelschiene (3) und dem Lotband (2) in benachbarten Zeilen liegen und zwischen einer positive und einer negativen Elektrode einer einzelnen Zeile der Zellen (1) parallel geschaltet sind, um einen Einzelzeilenschutz zu erzielen.

3. Lichtpunktbeständiges Einzelplattenfotovoltaikmodul nach Anspruch 1, wobei die Dioden (4) zwischen den um N Zeilen beabstandeten Lotbändern (2) und zwischen der Sammelschiene (3) und dem Lotband (2), die um N Zeilen beabstandet sind, liegen, und parallel zwischen einer positive und einer negativen Elektrode von mehreren Zeilen der Zellen (1) parallel geschaltet sind, um einen Mehrzeilenschutz zu erzielen, wobei N eine natürliche Zahl größer oder gleich 1 ist.

4. Lichtpunktbeständiges Einzelplattenfotovoltaikmodul nach Anspruch 1, wobei das lichtpunktbeständige Einzelplattenfotovoltaikmodul ferner einen Schaltkasten umfasst, wobei die Dioden (4) in dem Schaltkasten angeordnet sind und die Lotbänder (2) und die Sammelschienen (3) sich nach außen erstrecken, um mit den Dioden (4) im Schaltkasten verbunden zu sein.

5. Lichtpunktbeständiges Einzelplattenfotovoltaikmodul nach Anspruch 1, wobei die Zellen (1) jeweils eine scheibenförmige Zelle sind und die scheibenförmige Zelle durch Schneiden der Zelle aus kristallinem Silizium in 1/2 bis 1/12 gebildet ist, wobei die Zelle (1) ein beliebiges von 1/2, 1/3, 1/4, 1/5, 1/6, 1/7, 1/8, 1/9, 1/10, 1/11 und 1/12 ist.

## Revendications

1. Un module photovoltaïque monoplaque résistant aux points chauds, comprenant : des cellules (1), des rubans de soudure (2), deux barres omnibus (3), et des diodes (4), dans lequel une pluralité de cellules (1) est agencée en matrice et raccordée par les rubans de soudure (2) et les barres omnibus (3) pour former un réseau de cellules ; une barre omnibus est à la terminaison supérieure du réseau de cellules et l'autre barre omnibus bar est à la terminaison inférieure du réseau de cellules ;
les cellules (1) d'une même colonne de réseau de cellule sont raccordées en série par les rubans de soudure (2) ; les cellules de tête (1), ainsi que les cellules de queue (1) du réseau de cellules sont séparément raccordées par l'une des barres omnibus (3) pour collecter et conduire les courants à l'extérieur ; les diodes (4) sont situées entre les rubans de soudure (2) et entre les barres omnibus (3) et les rubans de soudure (2), et les diodes (4) sont raccordées en parallèle aux cellules (1) ; dans lequel les cellules (1) d'une rangée sont séparées par un espace ; les rubans de soudure (2) et les barres omnibus (3) sont parallèles au sens des cellules (1) d'une même rangée du réseau de cellules ; chacune des cellules (1) est une cellule de silicium cristallin, la cellule de silicium cristallin est une cellule solaire en bardeau ; **caractérisé en ce que**
les cellules (1) d'une même rangée du réseau de cellules sont raccordées en parallèle par deux des rubans de soudure (2) ou par un des rubans de soudure (2) et une des barres omnibus (3), dans lequel dans le cas de deux rubans de soudure (2) : l'un des rubans de soudure (2) est sur le côté avant des cellules (1) d'une même rangée du réseau de cellules, à la terminaison supérieure des cellules qui est parallèle au sens de rangée des cellules tandis que l'autre ruban de soudure est sur le côté arrière des cellules (1), à la terminaison inférieure des cellules (1) qui est parallèle au sens de rangée des cellules, dans le cas d'un ruban de soudure (2) et d'une barre omnibus (3) : un des rubans de soudure (2) et la barre omnibus (3) sont sur le côté avant des cellules (1) d'une même rangée de réseau de cellules, à la terminaison supérieure qui est parallèle au sens de rangée des cellules tandis que l'autre est au côté arrière des cellules (1), à la terminaison inférieure des cellules (1) qui est parallèle au sens de rangée des cellules ; la cellule (1) et le ruban de soudure (2) sont raccordés de façon parallèle, de sorte que de deux rubans de soudure (2) d'une même rangée ou d'un ruban de soudure (2) et d'une barre omnibus (3) d'une même rangée, un ruban de soudure est commun à deux rangées de cellules adjacentes, passe à travers la rangée entière de cellules, est pris en sandwich entre les deux rangées de cellules, est sur le côté avant des cellules d'une rangée et sur le côté arrière des cellules de l'autre rangée, et raccorde les cellules correspondantes des deux rangées en série à la manière de tuiles, et une barre omnibus (3) passe à travers la rangée entière de cellules.

2. Un module photovoltaïque monoplaque résistant aux points chauds selon la revendication 1, dans lequel les diodes (4) sont situées entre les rubans de soudure (2) dans des rangées adjacentes et entre les barres omnibus (3) et le ruban de soudure (2) dans les rangées adjacentes, et sont raccordées en parallèle entre les électrodes positive et négative d'une rangée unique de cellules (1) pour réaliser une protection de rangée unique.

3. Un module photovoltaïque monoplaque résistant aux points chauds selon la revendication 1, dans lequel les diodes (4) sont situées entre les rubans de soudure (2) espacés par N rangées et entre les barres omnibus (3) et le ruban de soudure (2) espacés par N rangées, et sont raccordées en parallèle entre les électrodes positive et négative de multiples rangées de cellules (1) pour réaliser une protection de rangées multiples, dans lequel N est un nombre naturel supérieur ou égal à 1.

4. Un module photovoltaïque monoplaque résistant aux points chauds selon la revendication 1, dans lequel le module photovoltaïque monoplaque résistant aux points chauds comprend en outre une boîte de jonction, dans laquelle les diodes (4) sont agencées dans la boîte de jonction, et les rubans de soudure (2) et les barres omnibus (3) se prolongent vers l'extérieur pour se raccorder aux diodes (4) dans la boîte de jonction.

5. Un module photovoltaïque monoplaque résistant aux points chauds selon la revendication 1, dans lequel chacune des cellules (1) est une cellule coupée, et la cellule coupée est formée en coupant la cellule de silicium cristallin de 1/2 à 1/12, dans laquelle la cellule (1) est l'une quelconque parmi 1/2, 1/3, 1/4, 1/5, 1/6, 1/7, 1/8, 1/9, 1/10, 1/11 et 1/12.
